(19) Europäisches Patentamt / European Patent Office / Office européen des brevets

(11) **EP 1 876 457 A1**

(12) **EUROPEAN PATENT APPLICATION**

(43) Date of publication:
**09.01.2008 Bulletin 2008/02**

(51) Int Cl.:
*G01R 31/12* *(2006.01)*

(21) Application number: **06445078.6**

(22) Date of filing: **22.12.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **ABB RESEARCH LTD.**
**8050 Zürich (CH)**

(72) Inventors:
• **Bengtsson, Tord**
**723 49 Västerås (SE)**

• **Sonerud, Björn**
**421 45 Västra Frölunda (SE)**
• **Blennow, Jörgen**
**428 30 Kållered (SE)**

(74) Representative: **Kock, Ina et al**
**ABB AB**
**Legal Affairs and Compliance/**
**Intellectual Property**
**Forskargränd 7**
**721 78 Västerås (SE)**

(54) **Method of monitoring losses**

(57) A method of monitoring high voltage insulation comprises using Fourier transformations of voltages and currents.

Fig. 1

EP 1 876 457 A1

# Description

## FIELD OF INVENTION

The present invention generally relates to a method of monitoring losses and particularly a method of monitoring losses in high voltage insulation.

## BACKGROUND

In electrical systems, losses appear in conductors, isolations etc., causing heating of the components in the system, such as electrical motors etc. The losses may often increase when the wave form of the voltages and currents deviate from sinusoidal curves. Such losses are of course particularly undesirable in high voltage systems, such as electronic drive systems.

Pulse-Width Modulated (PWM) drives and other drives utilizing non-sinusoidal voltage wave forms are becoming increasingly common in high voltage applications. The fast rise-time of the voltage waveform from such drives is known to subject the insulation system in the apparatuses connected to the drives to more severe stress than normal sinusoidal voltages. For such apparatuses, it is thus even more important to examine the insulation system status regularly or on-line.

A well-known method to examine insulation systems is dielectric response measurements, where the insulation loss is measured as a function of frequency. This provides more detailed information than a single-frequency loss factor measurement. Examples of the use of this method are disclosed in the published articles "Straight Dielectric Response Measurements with High Precision" by J. Hedberg and T. Bengtsson, Nord-IS 2005, paper 27, and "Dielectric Response Measurements utilizing non-sinusoidal waveforms" by B. Sonerud, T. Bengtsson, J. Blennow and S. M. Gubanski, Proceedings of CEIDP 2006, Kansas City, USA, pp. 43-46, these documents being incorporated herein by reference.

## SUMMARY OF THE INVENTION

An object of the present invention is to provide a method of on-line monitoring of electrical losses in high voltage insulation materials.

The invention is based on the realization that the harmonic content of a non-sinusoidal waveform enables dielectric response measurements to be performed on-line, i.e., in non-experimental environments.

According to the invention there is provided a method of monitoring high voltage insulation, comprising the following steps: obtaining voltage information by measuring the voltage across the insulation, obtaining current information by measuring the current through the insulation, transforming the voltage information and the current information from the time domain into the frequency domain, determining the characteristics of the insulation by analyzing the frequency domain voltage and current information, which method is characterised in that it is performed on-line at an on site installation.

By means of the inventive method, it is possible to monitor on-line changes in the insulation of for example electrical motor drives, possibly preventing breakdown thereof.

In a preferred embodiment, the measured voltage comprises non-sinusoidal voltages, preferably pulse width modulated voltages, which generate many harmonics.

Further preferred embodiments are defined by the dependent claims.

## BRIEF DESCRIPTION OF DRAWINGS

The invention is now described, by way of example, with reference to the accompanying drawings, in which:

Fig. 1 is an overview of a monitoring arrangement used with the method according to the invention,

Fig. 2 is a diagram showing monitored voltage and current as a function of time,

Fig. 3a is a diagram showing a Fourier transform spectrum of the voltage shown in the diagram of Fig. 2,

Fig. 3b is a diagram showing the curve of Fig. 3a but with the frequency scale enlarged ten times,

Fig. 4a is a diagram showing a Fourier transform spectrum of the current shown in the diagram of Fig. 2, and

Fig. 4b is a diagram showing the curve of Fig. 4a but with the frequency scale enlarged ten times,

## DETAILED DESCRIPTION OF PREFERRED EMBODIMENTS

In the following a detailed description of a preferred embodiment of the present invention will be given.

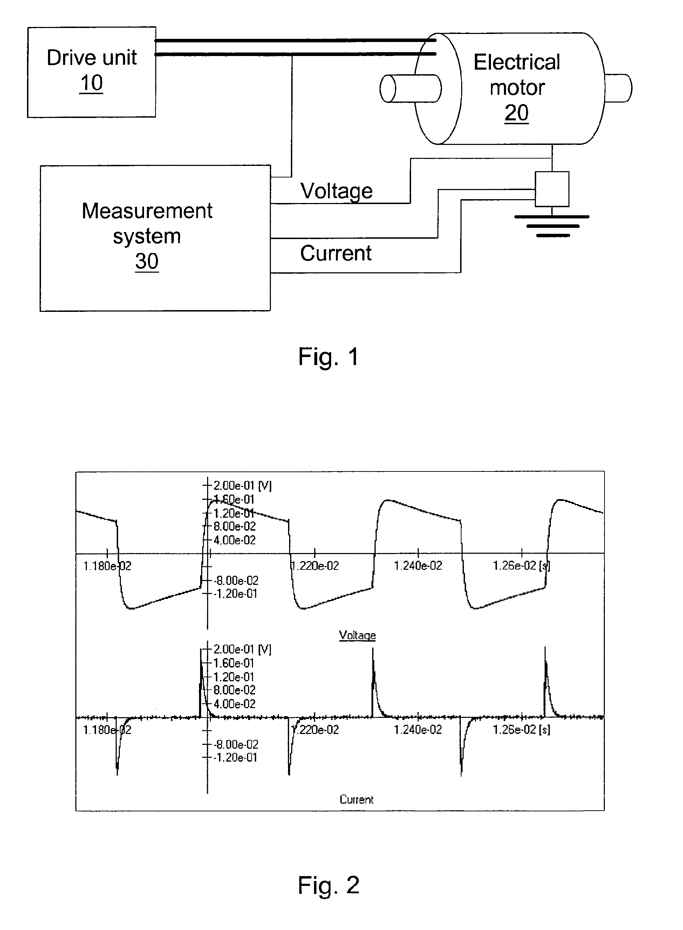

Fig. 1 shows an overview of a electrical motor drive system comprising an electronic motor drive unit 10, such as a drive unit providing voltages for feeding an electrical motor 20. The drive unit outputs non-sinusoidal voltages, such as pulse width modulated (PWM) voltages, for controlling the operation of the electrical motor 20, such as an induction motor, which is connected to the drive unit by means of three feed lines. Finally, a measurement or monitoring system 30 is connected to the three lines and to ground for monitoring voltages across the motor insulation and currents through the insulation. This insulation can comprise for example lacquer, epoxy-based materials, polymers, porcelain, and rubber etc.

An example of motor voltages and currents is given in Fig. 2, wherein the upper curve represents the voltage and the lower curve represents the current. In this preferred embodiment, the current to ground is measured.

Since the insulation is essentially capacitive - the current is essentially the time derivative of the voltage, dV/dt.

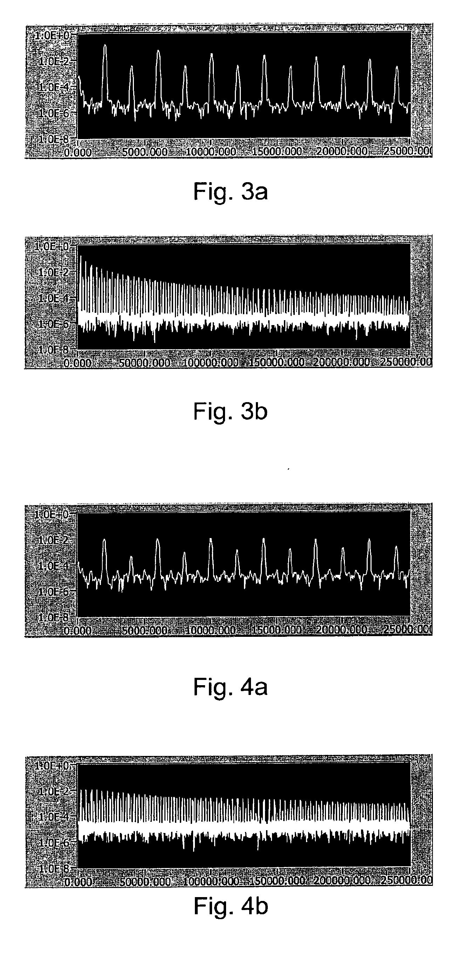

Fig. 3a shows a diagram of a Fourier transform spectrum of the voltage shown in the diagram of Fig. 2 and Fig. 3b shows the curve of Fig. 3a with the frequency scale enlarged ten times. Similarly, Fig. 4a shows a diagram of a Fourier transform spectrum of the current shown in the diagram of Fig. 2 and Fig. 4b shows the curve of Fig. 4a with the frequency scale enlarged ten times. These spectra can be obtained by means of suitable measuring devices, such as a 14 Bit, 100 MS/s digitizer (NI PCI 5122), and a current shunt containing low inductance resistors (metal-film resistors).

The operating principle of the circuit is based on measurements of the applied voltage and the voltage over the shunt, the latter representing the resulting current. The sharp edges in square voltage pulses are used to determine the content of the harmonics.

The invention is thus an on-line monitoring system for apparatuses powered by non-sinusoidal voltages where the applied voltage and the capacitive current through the insulation system are read with analogue-to-digital converters of sufficient speed and accuracy. These waveforms are then Fourier-analyzed and the dielectric response spectrum can be calculated for each harmonic from the basic switching frequency and up. Depending on the voltage rise-time, it is possible to use harmonics as high as the 100:th and above. However, the number of harmonics used is determined depending on the application.

The measuring device samples the voltage and current with as high sampling frequency as possible, and preferably ten times the highest frequency of interest. Also, for each measurement, at least ten periods of the measured signals are sampled.

The transformed voltages and currents are paired and the insulation capacitance is calculated for each pair of voltage and current transformations, i.e., for each harmonics as follows:

$$C_n = \frac{I_n}{i\,\omega_n\,V_n}$$

$$\tan(\delta_n) = \frac{\mathrm{Im}(C_n)}{\mathrm{Re}(C_n)}$$

wherein $V_n$ and $I_n$ are voltage and current amplitudes at the n:th harmonic, respectively, $C_n$ is the capacitance of the insulation at $\omega_n$, which is the frequency of the n:th harmonic. This information can be retrieved with relative ease from the measured voltage and current signals after a Fourier transform.

The inventive method is applied with ease to carrier frequencies from 1 kHz and upward.

The inventive method works best in steady state operation, since the information in the measured signals are repetitive, increasing accuracy of the method. However, it is also possible to perform the method in transient operation.

In a preferred embodiment, old measurements are used for comparison to detect changes. A reference curve is thereby provided and new measurements are compared with this reference curve.

By means of this on-line monitoring of a high voltage installation, changes in the insulation material can be predicted, thereby avoiding breakdown of a running motor. Thus, by means of the method, thermal runaway for example, which is caused by currents in certain harmonics, may be predicted and avoided.

A preferred embodiment of a method according to the invention has been described. A person skilled in the art realizes that this could be varied within the scope of the appended claims.

**Claims**

1. A method of monitoring high voltage insulation, comprising the following steps:

    - obtaining voltage information by measuring the voltage across the insulation,
    - obtaining current information by measuring the current through the insulation,
    - transforming the voltage information and the current information from the time domain into the frequency domain,
    - determining the characteristics of the insulation by analyzing the frequency domain voltage and current information,

    **characterised in that**

    - the method is performed on-line at an on site installation.

2. The method according to claim 1, wherein the measured voltage comprises non-sinusoidal voltages, preferably pulse width modulated voltages.

3. The method according to claim 1 or 2, wherein the high voltage insulation comprises any of the following: lacquer, epoxy-based materials, polymers, porcelain, and rubber.

4. The method according to any of claims 1-3, wherein the step of obtaining current information comprises measuring the current to ground.

5. The method according to any of claims 1-4, wherein harmonics up to the 100:th harmonic are used in the frequency domain.

6. The method according to any of claims 1-5, wherein the current and voltage information is obtained by sampling, and preferably with a sampling frequency of at least ten times the highest frequency of interest.

7. The method according to claim 6, wherein at least ten periods of the measured signals are sampled.

8. The method according to any of claims 1-7, wherein the method is applied to carrier frequencies of at least 1 kHz.

9. The method according to any of claims 1-8, wherein method is applied to steady state operation.

10. The method according to any of claims 1-9, wherein old measurements are used for comparison to detect changes.

**Fig. 1**

**Fig. 2**

Fig. 3a

Fig. 3b

Fig. 4a

Fig. 4b

**European Patent Office**

## EUROPEAN SEARCH REPORT

Application Number

EP 06 44 5078

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | SONERUD, B ET AL: "Dielectric response measurements utilizing non-sinusoidal waveforms" IEEE CONFERENCE ON ELECTRICAL INSULATION AND DIELECTRIC PHENOMENA, October 2006 (2006-10), pages 43-46, XP002437192 * the whole document * ----- | 1-10 | INV. G01R31/12 |

TECHNICAL FIELDS SEARCHED (IPC)

G01R

The present search report has been drawn up for all claims

| Place of search | Date of completion of the search | Examiner |
|---|---|---|
| Munich | 12 June 2007 | Dogueri, Kerem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **J. HEDBERG ; T. BENGTSSON.** Straight Dielectric Response Measurements with High Precision. *Nord-IS 2005, paper 27*

- **B. SONERUD ; T. BENGTSSON ; J. BLENNOW ; S. M. GUBANSKI.** Dielectric Response Measurements utilizing non-sinusoidal waveforms. *Proceedings of CEIDP 2006*, 43-46